# EUROPÄISCHE PATENTSCHRIFT

(11) **EP 3 746 749 B1**
(45) Veröffentlichungstag und Bekanntmachung des Hinweises auf die Patenterteilung: **22.05.2024**
(21) Anmeldenummer: 18822328.3
(22) Anmeldetag: 13.12.2018
(51) Int. Cl.: H10N 30/87, G01F 23/296, G10K 9/122, H04R 17/00, B06B 1/06

(54) **ULTRASCHALLWANDLER MIT EINER PIEZOKERAMIK UND VERFAHREN ZUR HERSTELLUNG EINES SOLCHEN ULTRASCHALLWANDLERS**
ULTRASONIC TRANSDUCER WITH A PIEZOCERAMIC AND METHOD FOR PRODUCING AN ULTRASONIC TRANSDUCER OF THIS KIND
TRANSDUCTEUR ULTRASONORE MUNI D'UNE PIÉZOCÉRAMIQUE ET PROCÉDÉ DE FABRICATION DUDIT TRANSDUCTEUR ULTRASONORE

(30) Priorität: 30.01.2018 DE 102018201404
(43) Veröffentlichungstag der Anmeldung: 09.12.2020
(73) Patentinhaber: PI Ceramic GmbH, 07589 Lederhose (DE)
(72) Erfinder: DITAS, Peter, 07589 Münchenbernsdorf (DE); SENNFELDER, Benjamin, 07570 Weida (DE)
(74) Vertreter: Grünecker Patent- und Rechtsanwälte PartG mbB
(86) Internationale Anmeldenummer: PCT/EP2018/084718
(87) Internationale Veröffentlichungsnummer: WO 2019/149418

(56) Entgegenhaltungen:
- EP-A2- 2 133 156
- CN-A- 106 558 649
- DE-A1-102005 012 041
- JP-A- 2011 250 327

## Beschreibung

Die Erfindung betrifft einen Ultraschallwandler mit einer Piezokeramik und ein Verfahren zur Herstellung eines solchen Ultraschallwandlers.

Ultraschallwandler, welche inzwischen in vielen Wasser- oder Wärmemengenzählern Einsatz finden und die klassischen mechanischen Durchflussmengenzähler mehr und mehr ersetzen, basieren in der Regel auf dem simplen Verbund einer aktiven Piezokeramikkomponente mit einer schalldurchlässigen Koppelschicht, z.B. einer Edelstahlmembran.

Für die elektrische Kontaktierung der Piezokomponente existieren verschiedene technische Lösungen. Eine Möglichkeit besteht in der Nutzung von Federkontakten, die allerdings im Hinblick auf die Lebensdauer ein Risiko hinsichtlich Kontakt-Korrosion darstellen können. Der Kontakt und die Berührungsstellen unterliegen im Betrieb einer dynamischen Beanspruchung, was langfristig zu einer Änderung der Übergangswiderstände führen kann. Das Design und die Fertigung derartiger Kontakte sind sehr anspruchsvoll. Eine gleichbleibende Qualität (Andruck) ist für die Funktion der Wandler zwingend erforderlich, um einen wartungsarmen Betrieb mit hoher Lebensdauer zu gewährleisten. In vielen Ultraschallwandlern wird die Kontaktierung auch mittels Löten von Drähten realisiert. Die Lötstellen auf der Piezokeramik stellen zusätzliche Massen dar, die einen Einfluss auf die Schwingdynamik des Wandlers haben. Speziell manuelle Lötprozesse unterliegen subjektiven Einflüssen und führen zu hohen Fertigungskosten.

Die DE 101 58 015 A1 offenbart einen solchen Ultraschallwandler, insbesondere für den Einsatz in einem Durchflussmesser für flüssiges oder gasförmiges Medium.

Eine Durchflussmengenmesseinrichtung ist aus der EP 2 267 416 A1 bekannt.

Die DE 198 20 208 A1 offenbart einen piezoelektrischen Schwinger, bei dem die Kontaktierung des piezoelektrischen Elements über eine zweipolige Zuführungsleitung erfolgt. Wie oben beschrieben, wirkt sich die dabei erforderliche Ausbildung von Lötstellen zur elektrischen Verbindung der Elektroden der Piezokeramik und der Zuführungsleitung nachteilig auf die Schwingdynamik des Ultraschallwandlers aus. Die Lötstellen sind dabei für jeden Pol der Zuführungsleitung gesondert auszubilden, was zu hohen Fertigungskosten führt.

Weitere Vorrichtungen sind in der CN 106 558 649 A, der JP 2011 250327 A und der DE 10 2005 012041 A1 offenbart.

Der Markt für Ultraschallwandler in Smart Metering Anwendungen unterliegt einem extremen Preisdruck.

Ausgehend von dem oben genannten Stand der Technik liegt der vorliegenden Erfindung die Aufgabe zugrunde, einen Ultraschallwandler mit hervorragender Medienbeständigkeit, verbesserter Schwingdynamik und einfacherem Aufbau durch Reduzierung der Anzahl von Einzelteilen bereitzustellen, sodass der Ultraschallwandler in einer vollautomatisierten Fertigung herstellbar ist.

Zur Lösung der Aufgabe offenbart die Erfindung einen Ultraschallwandler, insbesondere zur Fluidmengenmessung, gemäß Anspruch 1. Der erfindungsgemäße Ultraschallwandler umfasst ein Gehäuse, in welchem ein Kontaktelement und eine Piezokeramik angeordnet sind, wobei die Piezokeramik zwei Elektroden unterschiedlicher Polarität umfasst, die auf verschiedene Seiten der Piezokeramik aufgebracht sind, wobei Kontaktflächen zur elektrischen Kontaktierung beider Elektroden auf derselben Seite der Piezokeramik angeordnet sind, und das Kontaktelement wenigstens zwei Kontaktabschnitte unterschiedlicher Polarität aufweist, die mit den Kontaktflächen beider Elektroden entsprechender Polarität in elektrisch leitendem Kontakt stehen. Dadurch ist es möglich, die beiden Elektroden über dieselbe Seite der Piezokeramik elektrisch zu kontaktieren, sodass der Verbindungaufwand durch Reduzierung der erforderlichen Anzahl von Bauteilen zur Verkabelung deutlich sinkt. Über die beiden Kontaktabschnitte des Kontaktelements können die Kontaktflächen der Piezokeramik besonders günstig mit einer elektrischen Wechselspannung beaufschlagt werden. Insbesondere kann durch die Verwendung eines Kontaktelements, das zwei Kontaktabschnitte aufweist, ein direktes Gegenstück zu den Elektroden der Piezokeramik bereitgestellt werden, was den fertigungstechnischen Aufwand bei der Kontaktierung der Elektroden der Piezokeramik verringert.

Es kann sinnvoll sein, wenn die jeweiligen Kontaktabschnitte des Kontaktelements in flächigem Kontakt mit den entsprechenden Kontaktflächen der Elektroden stehen. Durch den flächigen Kontakt kann eine zuverlässige Kontaktierung der Elektroden ohne Einbringung von Zusatzmasse realisiert werden.

Es kann von Vorteil sein, wenn eine von der Piezokeramik abweisende Seite der ersten Elektrode die Kontaktfläche der ersten Elektrode bildet. Dadurch kann die erste Elektrode über deren Rückseite elektrisch kontaktiert werden.

Es kann sich aber auch als nützlich erweisen, wenn die erste Elektrode eine erste Seite der Piezokeramik teilweise bedeckt und/oder kontaktiert, wobei die erste Elektrode vorzugsweise mittig auf der ersten Seite der Piezokeramik angeordnet ist, bevorzugt derart, dass auf der ersten Seite der Piezokeramik eine ringförmige Fläche verbleibt, die nicht von der ersten Elektrode bedeckt ist. Diese Ausführung begünstigt die symmetrische Anregung der Piezokeramik bei Anlage einer elektrischen Wechselspannung an die Elektroden.

Es kann aber auch sinnvoll sein, wenn die zweite Elektrode eine zweite Seite der Piezokeramik vorzugsweise vollflächig bedeckt und/oder kontaktiert, wobei bevorzugt wenigstens eine Kontaktfläche der zweiten Elektrode auf der ersten Seite der Piezokeramik angeordnet ist und durch einen Umkontakt mit der zweiten Elektrode elektrisch leitend verbunden ist, wobei der Umkontakt vorzugsweise über eine dritte Seite der Piezokeramik verläuft. Der Umkontakt bietet eine hervorragende Möglichkeit, die Kontaktfläche der zweiten Elektrode von dem elektrisch wirksamen Bereich der zweiten Elektrode zu trennen.

Es kann sich auch als hilfreich erweisen, wenn die zweite Elektrode zwei, drei, vier oder mehr Kontaktflächen aufweist, die vorzugsweise identisch ausgebildet und/oder symmetrisch und/oder äquidistant um die erste Elektrode angeordnet sind, bevorzugt randseitig auf der ersten Seite der Piezokeramik. Diese Ausführung begünstigt die Erzeugung einer besonders symmetrischen Schwingung der Piezokeramik.

Es kann nützlich sein, wenn die Piezokeramik als Piezokeramikscheibe oder-platte ausgebildet ist und/oder sich in einer Ebene erstreckt. Derartige Gestaltungsformen sind besonders kompakt und kostengünstig aus piezoelektrischem bzw. piezokeramischem Material herstellbar.

Es kann auch sinnvoll sein, wenn das Gehäuse aus Keramik wie beispielsweise Aluminiumoxid oder aus Kunststoff wie beispielsweise PPS hergestellt ist, vorzugsweise in einem Gieß- bzw. Spritzgussverfahren.

Es kann sich überdies als praktisch erweisen, wenn sich die Kontaktabschnitte auf derselben Oberfläche des Kontaktelements und/oder in derselben Ebene befinden. Dadurch ist eine besonders einfache Kontaktierung der Kontaktflächen beider Elektroden der Piezokeramik möglich.

Erfindungsgemäß ist das Kontaktelement topfförmig ausgebildet, wobei die Kontaktabschnitte am Boden des Kontaktelements angeordnet sind und über vom Boden vorstehende Randabschnitte des Kontaktelements elektrisch kontaktierbar sind. Diese Bauform des Kontaktelements ist besonders stabil und bietet durch die vom Boden vorstehende Randabschnitte des Kontaktelements eine Auflagefläche für einen Deckel. Durch den Deckel kann das die Piezokeramik aufnehmende Gehäuse einerseits verschlossen werden, andererseits kann durch den Deckel eine Kontaktierung der Randabschnitte des Kontaktelements bewerkstelligt werden.

Es kann nützlich sein, wenn das Kontaktelement einen Teil des Gehäuses bildet und/oder als Membran ausgebildet ist, über welche die akustische Kopplung der Piezokeramik erfolgt, wobei die Piezokeramik vorzugsweise vollflächig mit dem Kontaktelement verklebt ist. Bei dieser Ausführung kann die Anzahl der Bauteile minimiert werden.

Es kann aber auch sinnvoll sein, wenn die Kontaktabschnitte als Beschichtung oder Metallisierung auf das Kontaktelement aufgebracht sind oder durch Einbettung elektrisch leitfähiger Materialien, vorzugsweise in Partikelform, in das Kontaktelement eingearbeitet sind. Insbesondere kann das Kontaktelement aus einem elektrisch isolierenden Material hergestellt sein, wobei im Nachgang die entsprechenden Kontaktabschnitte durch die genannten Techniken ausgebildet werden. Dadurch lassen sich mit geringem Aufwand viele verschiedene Ausführungen von Kontaktelementen herstellen.

Es kann aber auch von Nutzen sein, wenn das Gehäuse einen Deckel mit Elektroden unterschiedlicher Polarität aufweist, wobei die Elektroden bei geschlossenem Deckel in elektrisch leitender Verbindung mit den Kontaktabschnitten entsprechender Polarität stehen, sodass die Piezokeramik über die Elektroden des Deckels mit einer Wechselspannung beaufschlagbar ist. Bei dieser Ausführung sind die Piezokeramik und das Kontaktelement im Inneren eines geschlossenen Gehäuses geschützt. Überdies ist die Herstellung des Kontakts zwischen der Piezokeramik und dem Kontaktelement an den Schließzustand des Deckels gekoppelt, sodass bereits optisch - nämlich durch Überprüfung des Schließzustands des Deckels - auch die Herstellung des Kontakts zwischen der Piezokeramik und dem Kontaktelement verifiziert werden kann.

Es kann sich aber auch als vorteilhaft erweisen, wenn die Elektroden bei geschlossenem Deckel an der Außenseite des Deckels angeordnet sind und vorzugsweise über Durchkontaktierung mit Anschlüssen entsprechender Polarität an der Innenseite des Deckels in elektrisch leitender Verbindung stehen, wobei die Anschlüsse an der Innenseite des Deckels bei geschlossenem Deckel mit den Kontaktabschnitten entsprechender Polarität in elektrisch leitender Verbindung und/oder in Kontakt stehen. Bei dieser Ausführung kann die Beaufschlagung der Piezokeramik mit einer elektrischen Wechselspannung besonders einfach und komfortabel erfolgen, während die Piezokeramik und das Kontaktelement im Inneren eines geschlossenen Gehäuses geschützt sind.

Ein weiterer Aspekt der vorliegenden Erfindung betrifft ein Verfahren zur Herstellung eines Ultraschallwandlers nach der vorangehenden Ausführung, umfassend die Schritte:
a. Anordnen der Piezokeramik in dem Gehäuse, sodass die Kontaktflächen der Piezokeramik mit den Kontaktabschnitten entsprechender Polarität des Kontaktelements in elektrisch leitendem Kontakt stehen;
b. Verschließen des Gehäuses mit dem Deckel.

Die vorstehend genannten Vorteile zur vorangehenden Ausführung des Ultraschallwandlers gelten für das Verfahren zu dessen Herstellung entsprechend.

Wichtige Begriffe und Definitionen im Zusammenhang mit der beanspruchten Erfindung werden nachstehend erläutert:
Begriffe und Definitionen

Der Begriff Fluid bezeichnet eine Flüssigkeit oder ein Gas.

Der Begriff Piezokeramik bezeichnet ein piezoelektrisches Element, das insbesondere scheibenförmig ausgebildet ist und sich vorzugsweise in einer Ebene erstreckt.

Die Piezokeramik kann folgende Merkmale aufweisen:
- Die Piezokeramik besteht aus einem piezokeramischen Material.
- Die Piezokeramik ist als Scheibe oder Platte ausgebildet.
- Die Piezokeramik umfasst eine erste Seite und eine davon abweisende zweite Seite, wobei die erste Seite und die zweite Seite vorzugsweise exakt oder im Wesentlichen parallel zueinander angeordnet sind.
- Die Piezokeramik weist eine Kreisscheibenform oder eine flachzylindrische Form auf, deren axialen Endseiten die erste und zweite Seite der Piezokeramik bilden, wobei die Mantelfläche eine dritte Seite der Piezokeramik bildet.

Die erste Elektrode kann folgende Merkmale aufweisen:
- Die erste Elektrode weist eine Kreisscheibenform auf.
- Die erste Elektrode ist mittig auf der ersten Seite der Piezokeramik angeordnet.
- Die erste Elektrode ist mit ihrer gesamten Fläche auf die erste Seite der Piezokeramik aufgebracht, vorzugsweise durch einen Sputter-Prozess.
- Die erste Elektrode bedeckt die erste Seite der Piezokeramik teilweise, sodass außerhalb der ersten Elektrode ein vorzugsweise ringförmiger Rand auf der ersten Seite der Piezokeramik verbleibt, der nicht von der ersten Elektrode bedeckt ist.
- Die erste Elektrode weist auf ihrer von der Piezokeramik abweisenden Seite eine Kontaktfläche zur elektrischen Kontaktierung der ersten Elektrode auf.

Die zweite Elektrode kann folgende Merkmale aufweisen:
- Die zweite Elektrode weist eine Kreisscheibenform auf.
- Die zweite Elektrode ist auf der zweiten Seite der Piezokeramik angeordnet.
- Die zweite Elektrode bedeckt die zweite Seite der Piezokeramik vollflächig.
- Die zweite Elektrode ist mit ihrer gesamten Fläche auf die zweite Seite der Piezokeramik aufgebracht, vorzugsweise durch einen Sputter-Prozess.
- Die zweite Elektrode umfasst wenigstens eine Kontaktfläche, die auf derselben Seite der Piezokeramik angeordnet ist wie eine Kontaktfläche der ersten Elektrode, wobei die Kontaktfläche über einen Umkontakt mit dem auf der zweiten Seite der Piezokeramik angeordneten Teil der zweiten Elektrode verbunden ist. Der Umkontakt ist vorzugsweise als bandförmiger Flachleiter ausgebildet und verläuft wenigstens über eine dritte Seite der Piezokeramik.
- Die zweite Elektrode umfasst zwei, drei, vier oder mehr Kontaktflächen, die vorzugsweise symmetrisch und/oder äquidistant auf derselben Seite der Piezokeramik angeordnet sind wie eine Kontaktfläche der ersten Elektrode. Die Kontaktflächen sind vorzugsweise randseitig auf der entsprechenden Seite der Piezokeramik angeordnet. Die Form jeder Kontaktfläche kann exakt oder im Wesentlichen einem Halbkreis entsprechen. Bevorzugt weist die zweite Elektrode vier identisch ausgebildete, vorzugsweise halbkreisförmige Kontaktflächen auf, die in Winkelabständen von etwa 90° symmetrisch und äquidistant auf der ersten Seite der Piezokeramik angeordnet sind.

Das Kontaktelement kann folgende Merkmale aufweisen:
- Das Kontaktelement ist kreisscheibenförmig ausgebildet.
- Das Kontaktelement weist einen ersten Kontaktabschnitt auf, der streifenförmig diametral über eine erste Seite des Kontaktelements verläuft, wobei in der Mitte der erste Seite des Kontaktelements ein vorzugsweise im Wesentlichen kreisförmiger Abschnitt ausgebildet ist, der auf die Form und Abmessungen der Kontaktfläche der ersten Elektrode der Piezokeramik abgestimmt ist, um die Kontaktfläche der ersten Elektrode der Piezokeramik im verbunden Zustand vollflächig zu kontaktieren.
- Das Kontaktelement weist zwei zweite Kontaktabschnitte auf, die auf der ersten Seite des Kontaktelements beiderseits des ersten Kontaktabschnitts und isoliert davon angeordnet sind, um die Kontaktflächen der zweiten Elektrode der Piezokeramik im verbunden Zustand zu kontaktieren.
- Das Kontaktelement ist topfförmig ausgebildet, wobei ein vorzugsweise umlaufender Rand randseitig von der ersten Seite bzw. vom Boden des Kontaktelements vorsteht, wobei Randabschnitte zur elektrischen Kontaktierung der Kontaktabschnitte am oberen Rand des Kontaktelements ausgebildet sind. Der Überstand der Randabschnitte über den Boden des Kontaktelements ist vorzugsweise größer als die Höhe der Piezokeramik. Der Innendurchmesser oder Innenumfang des vom Boden des Kontaktelements vorstehenden Rands liegt vorzugsweise im Bereich von 120 bis 200 % des Außendurchmessers oder Außenumfangs der Piezokeramik.
- Das Kontaktelement ist als Membran zur akustischen Kopplung der Piezokeramik ausgebildet.
- Das Kontaktelement ist mit der Piezokeramik fest verbunden, vorzugsweise verklebt.
- Das Kontaktelement ist aus einem elektrisch isolierenden Material hergestellt, wobei die ersten und zweiten Kontaktabschnitte aus elektrisch leitendem Material nachträglich auf das Kontaktelement aufgetragen sind, beispielsweise als Metallisierung oder als Beschichtung, oder wobei die ersten und zweiten Kontaktabschnitte aus elektrisch leitendem Material in Form von eingebetteten elektrisch leitfähigen Partikeln in das Kontaktelement eingearbeitet sind.

Das Gehäuse kann folgende Merkmale aufweisen:
- Das Gehäuse umfasst ein topfförmiges Gehäuseunterteil und einen Deckel.
- Der Deckel des Gehäuses umfasst eine Leiterplatte oder ist als Leiterplatte ausgebildet. Die Leiterplatte kann Elektroden unterschiedlicher Polarität zur Beaufschlagung der Piezokeramik mit einer elektrischen Wechselspannung umfassen. Die Elektroden der Leiterplatte liegen bei geschlossenem Gehäuse vorzugsweise auf der Außenseite der Leiterplatte bzw. des Gehäuses. Die Elektroden der Leiterplatte sind vorzugsweise mit Anschlüssen entsprechender Polarität an der Innenseite der Leiterplatte verbunden, beispielsweise im Wege der Durchkontaktierung. Die Leiterplatte ist vorzugsweise nur in einer bestimmten Drehstellung am Gehäuseunterteil montierbar, sodass die Anschlüsse bei geschlossenem Deckel in elektrisch leitenden Kontakt mit den Randabschnitten zur elektrischen Kontaktierung der Kontaktabschnitte des Kontaktelements stehen. Der Kontaktdruck zwischen den Anschlüssen und den Randabschnitten zur elektrischen Kontaktierung der Kontaktabschnitte des Kontaktelements kann beispielsweise durch Anpressen des Deckels bedarfsweise erhöht werden. Die Anschlüsse sind nach Form und Abmessungen vorzugsweise auf die Positionen der Randabschnitte zur elektrischen Kontaktierung der Kontaktabschnitte des Kontaktelements abgestimmt.
- Das Gehäuse ist aus einem elektrisch isolierenden Material hergestellt.
- Das Gehäuse besteht aus Konstruktionskeramik, vorzugsweise Aluminiumoxid.
- Das Gehäuse besteht aus Kunststoff, vorzugsweise aus PPS. Zumindest das topfförmige Gehäuseunterteil ist vorzugsweise aus Kunststoff im Spritzgussverfahren hergestellt.
- Das Gehäuse umfasst eine flachzylindrische und vorzugsweise rotationssymmetrische Form.
- Das Gehäuse umfasst einen Durchmesser der im Bereich von 150 bis 300 % des Durchmessers der Piezokeramik liegt.
- Das Gehäuse umfasst eine Höhe bzw. axiale Länge, die im Bereich von 150 bis 500 % der Höhe bzw. axialen Länge der Piezokeramik liegt.
- Die Piezokeramik und/oder das Kontaktelement ist/sind mittig im Gehäuse bzw. konzentrisch zu einer Achse des Gehäuses angeordnet.

Weitere vorteilhafte Weiterbildungen der vollen Erfindung ergeben sich durch Kombinationen der Merkmale, die in der Beschreibung, den Ansprüchen und den Zeichnungen offenbart sind.

### Kurze Beschreibung der Figuren

Es zeigen:

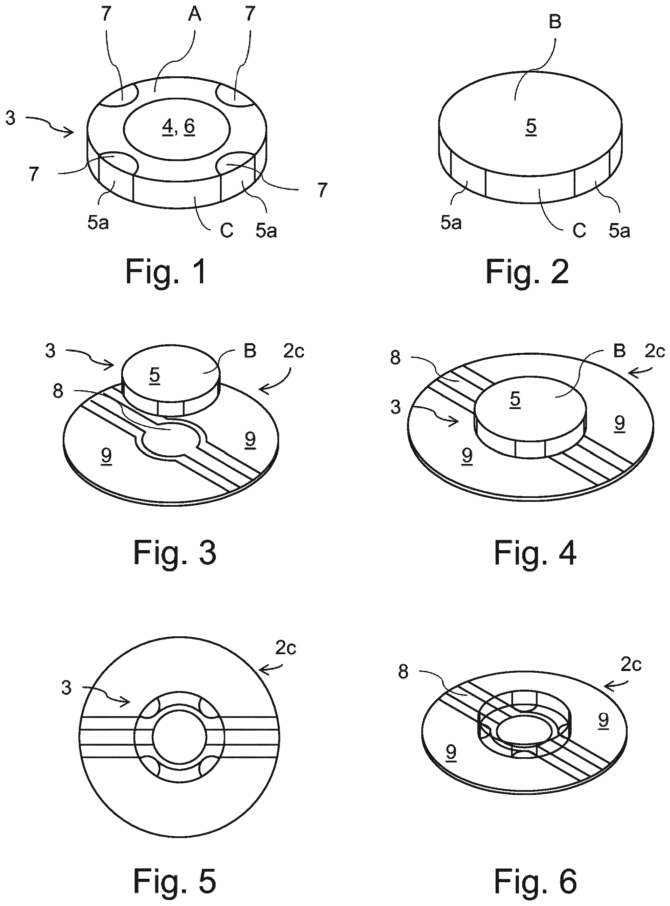

- Fig. 1: eine perspektivische Ansicht einer Piezokeramik des erfindungsgemäßen Ultraschallwandlers mit Blick auf die erste Seite (Unterseite), wobei die Piezokeramik als flachzylindrische Piezokeramikscheibe ausgebildet ist und die erste Elektrode (Plus) kreisförmig ausgebildet und mittig vollflächig auf die erste Seite (Unterseite) der Piezokeramik durch einen Sputter-Prozess aufgebracht ist, sodass auf der ersten Seite der Piezokeramik ein ringförmiger Rand verbleibt, der nicht von der ersten Elektrode bedeckt ist und in welchem insgesamt vier halbkreisförmige Kontaktflächen der zweiten Elektrode (Minus) randseitig symmetrisch und äquidistant beanstandet zueinander angeordnet sind.
- Fig. 2: eine perspektivische Ansicht der Piezokeramik gemäß Figur 1 mit Blick auf die zweite Seite (Oberseite), die mit einer zweiten kreisförmigen vollflächig durch einen Sputter-Prozess aufgebrachten Elektrode (Minus) bedeckt ist, wobei Umkontakte von der zweiten Elektrode über die Mantelfläche der Piezokeramik zu den Kontaktflächen der zweiten Elektrode auf der ersten Seite der Piezokeramik führen.
- Fig. 3: eine perspektivische Explosionsansicht einer Anordnung umfassend die Piezokeramik gemäß Figur 2 sowie ein Kontaktelement mit Kontaktabschnitten unterschiedlicher Polarität, die mit den Kontaktflächen der Piezokeramik zur Herstellung einer elektrisch leitenden Verbindung in Kontakt bringbar sind, wobei das Kontaktelement kreisscheibenförmig ausgebildet ist und der erste Kontaktabschnitt (Plus) streifenförmig diametral über den Mittelpunkt des Kontaktelements verläuft, um einen kreisförmigen Mittelabschnitt zu bilden, und wobei zwei zweite Kontaktabschnitte (Minus) beiderseits des ersten Kontaktabschnitts angeordnet und im Wesentlichen halbkreisförmig ausgebildet sind.
- Figur 4: eine perspektivische Ansicht der Anordnung gemäß Figur 3 in einem Zustand, in welchem die Piezokeramik bestimmungsgemäß auf dem Kontaktelement angeordnet ist, sodass die Kontaktflächen der Piezokeramik mit den Kontaktabschnitten entsprechender Polarität des Kontaktelements in elektrisch leitendem Kontakt stehen.
- Figur 5: eine Unteransicht der Anordnung gemäß Figur 4, wobei das Kontaktelement teiltransparent dargestellt ist.
- Figur 6: eine perspektivische Ansicht der Anordnung gemäß den Figur 4 oder 5 mit Blick auf die zweite Seite (Oberseite) der Piezokeramik, wobei die Piezokeramik teiltransparent dargestellt ist.

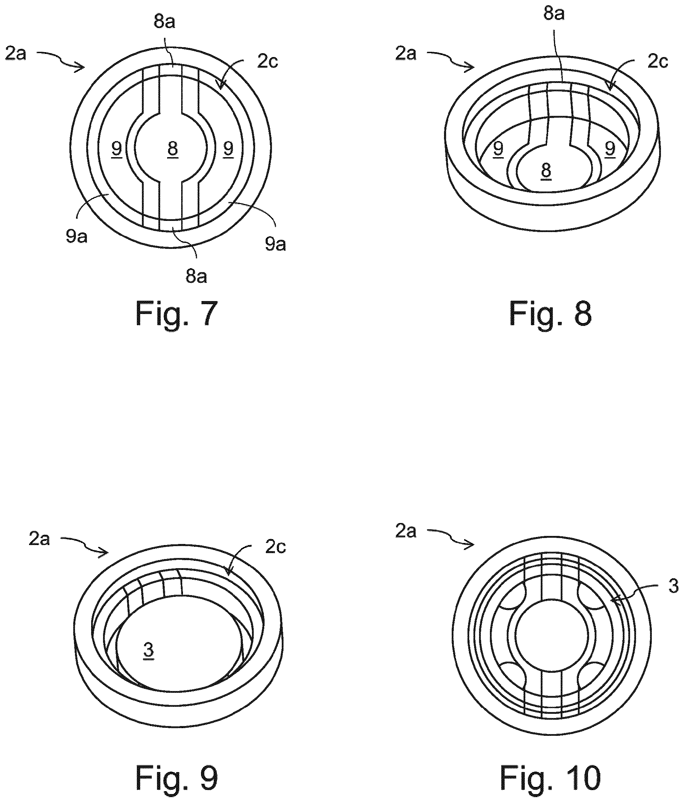

- Figur 7: eine Draufsicht einer erfindungsgemäßen Anordnung umfassend ein topfförmiges Gehäuseunterteil und ein topfförmiges Kontaktelement, wobei das Kontaktelement ähnlich zu dem in Fig. 3 dargestellten Kontaktelement ausgebildet ist und sich zusätzlich randseitig vom Boden des Kontaktelements ein umlaufender Rand erhebt, wobei die Kontaktabschnitte unterschiedlicher Polarität am Boden des Kontaktelements über entsprechende Randabschnitte am oberen Ende des umlaufenden Randes kontaktiert werden können.
- Figur 8: eine perspektivische Draufsicht der erfindungsgemäßen Anordnung gemäß Figur 7.
- Figur 9: eine perspektivische Draufsicht der Anordnung gemäß Figur 7, in einem Zustand, in welchem eine Piezokeramik gemäß Figur 2 bestimmungsgemäß auf dem Kontaktelement angeordnet ist, sodass die Kontaktflächen der Piezokeramik mit den Kontaktabschnitten entsprechender Polarität des Kontaktelements in elektrisch leitendem Kontakt stehen.
- Figur 10: eine Unteransicht der Anordnung gemäß Figur 9, wobei das Gehäuseunterteil sowie das Kontaktelement teiltransparent dargestellt sind.

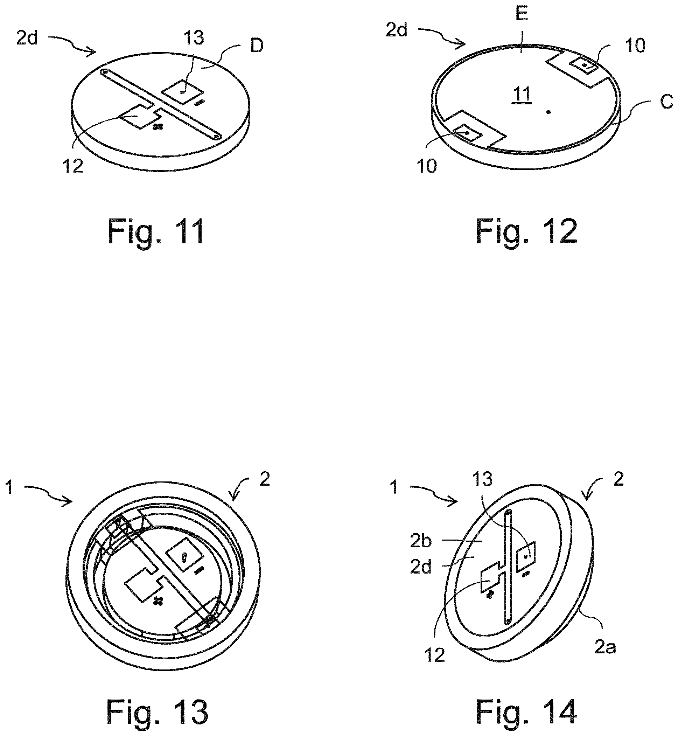

- Fig. 11: eine perspektivische Draufsicht einer Leiterplatte mit Elektroden unterschiedlicher Polarität, über welche eine elektrische Wechselspannung an die Elektroden der Piezokeramik anlegbar ist, wobei die Leiterplatte einen Deckel zum Verschluss des in den Figuren 7 bis 10 dargestellten Gehäuseunterteils bildet.
- Fig. 12: eine perspektivische Unteransicht der Leiterplatte gemäß Fig. 11, wobei an der Unterseite bzw. Innenseite der Leiterplatte Anschlüsse unterschiedlicher Polarität zur Kontaktierung der Randabschnitte entsprechender Polarität des in den Figuren 7 bis 9 dargestellten Kontaktelements angeordnet sind, wobei die Anschlüsse im Wege der Durchkontaktierung elektrisch leitend mit den Elektroden an der Außenseite in Verbindung stehen.
- Fig. 13: eine perspektivische Draufsicht eines erfindungsgemäßen Ultraschallwandlers, umfassend die in Figur 9 dargestellte Anordnung in Verbindung mit der in Figur 2 dargestellten Piezokeramik, wobei die Leiterplatte das in den Figuren 7 bis 10 dargestellte Gehäuseunterteil verschließt, sodass die Anschlüsse an der Deckelinnenseite mit den Randabschnitten entsprechender Polarität des Kontaktelements in elektrisch leitendem Kontakt stehen, wobei die Leiterplatte teiltransparent dargestellt ist.
- Fig. 14: eine andere perspektivische Draufsicht des erfindungsgemäßen Ultraschallwandlers gemäß Figur 13.

### Detaillierte Beschreibung der bevorzugten Ausführungsbeispiele

Die bevorzugten Ausführungsbeispiele der vorliegenden Erfindung werden nachstehend mit Bezug auf die beigefügten Zeichnungen im Detail beschrieben.

Das bevorzugte Ausführungsbeispiel der Erfindung umfasst einen Ultraschallwandler 1 in Gestalt eines medienbeständigen Ultraschall-Transducers bestehend aus einem topfartigen Gehäuse 2 aus Konstruktionskeramik (z.B. Aluminiumoxid) mit einer strukturierten Elektrode im Boden in Gestalt des mit Kontaktabschnitten 8, 9 ausgebildeten Kontaktelements 2c, worauf eine strukturierte Piezokeramik 3 mit speziell angepasstem Umkontaktdesign geklebt wird (vgl. Figuren 1 bis 6). Während durch die Oxid-Keramik ein chemisch beständiges Material als Membran verwendet und durch die strukturierte Metallisierung des Kontaktelements 2c in Gestalt der Kontaktabschnitte 8, 9 die elektrische Leitfähigkeit ermöglicht wird, besteht die Innovation darin, die Piezokeramik 3 ausschließlich über den Topf elektrisch zu kontaktieren. Die Piezokeramik 3 muss also nicht zusätzlich durch Federstifte oder Drähte kontaktiert und damit belastet oder gedämpft werden. Durch eine in das Gehäuse 2 eingeklebte Leiterplatte 2d oder Platine wird der Sensor abschließend verschlossen und kann darüber letztendlich beliebig kontaktiert werden.

Das alternative Prinzip der Kontaktierung über eine strukturierte Elektrode lässt sich natürlich nicht nur auf einen Topf, sondern auch auf eine anders geformte bzw. gestaltete Membran übertragen.

Eine Ausführung des Gehäuses in Kunststoff (z.B. PPS) ist auch denkbar. In Spritzgusstechnik können z.B. Stanzgitter zur elektrischen Kontaktierung eingespritzt werden. Eine andere Alternative zur Herstellung der speziellen Elektrodenstruktur im Gehäuse besteht in der Metallisierung des Kunststoffs, auch auf diesem Gebiet gibt es technische Lösungen.

### Im Detail umfasst der erfindungsgemäße Ultraschallwandler 1 folgende Komponenten:

Die Figuren 1 und 2 zeigen eine Ausführung einer Piezokeramik 3 für einen erfindungsgemä-ßen Ultraschallwandler 1 zur Fluidmengenmessung. Die Piezokeramik 3 ist flachzylindrisch bzw. kreisscheibenförmig ausgebildet und erstreckt sich im Wesentlichen in einer Ebene, wobei zwei kreisförmige Elektroden 4, 5 unterschiedlicher Polarität auf verschiedene Seiten A, B der Piezokeramik 3 aufgebracht sind. Die Dicke der Piezokeramik 3 bzw. der Abstand der beiden Seiten A, B liegt etwa im Bereich von 10 % bis 25 % des Durchmessers der Piezokeramik 3.

Die erste Elektrode 4 bedeckt und kontaktiert eine erste Seite Ader Piezokeramik 3 teilweise und ist mittig auf der ersten Seite A der Piezokeramik 3 flächig durch einen Sputter-Prozess aufgebracht. Rings um die erste Elektrode 4 verbleibt auf der ersten Seite Ader Piezokeramik 3 eine ringförmige Fläche, die nicht von der ersten Elektrode 4 bedeckt ist. Eine von der Piezokeramik 3 abweisende Seite der ersten Elektrode 4 bildet die Kontaktfläche 6 der ersten Elektrode 4.

Die flächig mittels eines Sputter-Prozesses aufgebrachte zweite Elektrode 5 bedeckt und kontaktiert eine zweite Seite B der Piezokeramik 3 vollflächig. Insgesamt vier Kontaktflächen 7 der zweiten Elektrode 5 sind randseitig symmetrisch und äquidistant in Winkelabständen von ca. 90° zur Mittelachse der Piezokeramik 3 auf der ersten Seite Ader Piezokeramik 3 angeordnet und jeweils durch einen über die Mantelfläche C der Piezokeramik 3 verlaufenden Umkontakt 5a mit dem aktiven Teil der zweiten Elektrode 5 elektrisch leitend verbunden. Folglich sind die Kontaktflächen 6, 7 zur elektrischen Kontaktierung beider Elektroden 4, 5 auf derselben Seite A der Piezokeramik 3 angeordnet. Die Kontaktflächen 7 der zweiten Elektrode 5 sind im Wesentlichen halbkreisförmig ausgebildet.

In den Figuren 3 bis 6 ist zusätzlich zu der in den Figuren 1 und 2 dargestellten Piezokeramik 3 ein Kontaktelement 2c dargestellt, welches wenigstens zwei Kontaktabschnitte 8, 9 unterschiedlicher Polarität aufweist, die mit den Kontaktflächen 6, 7 beider Elektroden 4, 5 entsprechender Polarität in elektrisch leitenden Kontakt gebracht werden können.

Das Kontaktelement 2c ist in der Ausführung gemäß den Figuren 3 bis 6 kreisscheibenförmig ausgebildet und erstreckt sich in einer Ebene. Der Durchmesser des Kontaktelements 2c liegt etwa im Bereich von 150 % bis 300 % des Durchmessers der Piezokeramik 3. Ein erster Kontaktabschnitt 8 zur Kontaktierung der ersten Elektrode 4 (Plus) der Piezokeramik 3 erstreckt sich im Wesentlichen streifenförmig diametral über die Oberfläche des Kontaktelements 2c, um in der Mitte der Oberfläche des Kontaktelements 2c einen in etwa kreisscheibenförmigen Abschnitt zu bilden, der zur Kontaktierung mit der Kontaktfläche 6 der ersten Elektrode 4 bestimmt ist und in seinen Abmessungen auf die Kontaktfläche 6 der ersten Elektrode 4 abgestimmt ist. Der erste Kontaktabschnitt 8 wird randseitig von isolierenden Abschnitten flankiert, die den ersten Kontaktabschnitt 8 von den beiderseits davon angeordneten und im Wesentlichen halbkreisförmig ausgebildeten zweiten Kontaktabschnitten 9 trennen. Die zweiten Kontaktabschnitte 9 sind dafür vorgesehen und ausgebildet, um mit den Kontaktflächen 7 der zweiten Elektrode 5 in elektrisch leitenden Kontakt zu gelangen, wenn die Piezokeramik 3 bestimmungsgemäß auf dem Kontaktelement 2c angeordnet und flächig damit verklebt ist. Die ersten und zweiten Kontaktabschnitte 8, 9 befinden sich in derselben Ebene und auf derselben Oberfläche des Kontaktelements 2c. Das Kontaktelement 2c kann als Membran ausgebildet sein, über welche die akustische Kopplung der Piezokeramik 3 erfolgt. Die Kontaktabschnitte 8, 9 sind beispielsweise als Beschichtung oder Metallisierung auf das Kontaktelement 2c aufgebracht oder sind durch Einbettung elektrisch leitfähiger Materialien, beispielsweise in Partikelform, in das Kontaktelement 2c eingearbeitet.

In alternativer Ausführung gemäß den Figuren 7 bis 10 kann das Kontaktelement 2c topfförmig ausgebildet sein und in einen unteren topfförmigen Gehäuseteil 2a eingesetzt sein oder einen Teil des Gehäuses 2 bilden, wobei die ersten und zweiten Kontaktabschnitte 8 und 9 im Wesentlichen analog zu der Ausführung gemäß den Figuren 3 bis 6 am Boden des Kontaktelements 2c angeordnet sind, während abweichend von den Figuren 3 bis 6 Randabschnitte 8a, 9a zur elektrischen Kontaktierung der Kontaktabschnitte 8 und 9 randseitig vom Boden des Kontaktelements 2c vorstehen. Die Abmessungen der durch den unteren topfförmigen Gehäuseteil 2a gebildeten Aufnahme übertreffen die Abmessungen der Piezokeramik 3, sodass die Piezokeramik 3 vollständig in der Aufnahme eingehaust ist.

Die Figuren 11 und 12 zeigen eine Leiterplatte 2d, die einen Deckel 2b zum Verschluss des unteren topfförmigen Gehäuseteils 2a gemäß den Figuren 7 bis 10 bildet.

Figuren 13 und 14 zeigen einen erfindungsgemäßen Ultraschallwandler 1, der insbesondere zur Fluidmengenmessung ausgebildet ist. Dieser Ultraschallwandler 1 umfasst ein Gehäuse 2, das aus dem unteren topfförmigen Gehäuseteil 2a gemäß den Figuren 7 bis 10 und dem als Leiterplatte 2d ausgebildeten Deckel 2b gemäß den Figuren 11 und 12 besteht. Das Gehäuse 2 kann aus Keramik - wie beispielsweise Aluminiumoxid - oder aus Kunststoff - wie beispielsweise PPS - hergestellt werden, wobei ein aus Kunststoff hergestelltes Gehäuse vorzugsweise in einemGieß- oder Spritzgussverfahren gefertigt ist. In dem Gehäuse sind ein Kontaktelement 2c und eine Piezokeramik 3 gemäß den Figuren 1 und 2 derart angeordnet, dass die Kontaktabschnitte 8, 9 unterschiedlicher Polarität des Kontaktelements 2c mit den Kontaktflächen 6, 7 beider Elektroden 4, 5 entsprechender Polarität in elektrisch leitendem Kontakt stehen

An einer ersten Seite D weist der Deckel 2b Elektroden 12, 13 unterschiedlicher Polarität auf, die bei geschlossenem Deckel 2b an der Außenseite des Deckels 2b bzw. des Gehäuses 2 angeordnet sind und über die Randabschnitte 8a, 9a in elektrisch leitender Verbindung mit den Kontaktabschnitten 8, 9 entsprechender Polarität stehen, sodass die Piezokeramik 3 über die Elektroden des Deckels 2b mit einer Wechselspannung beaufschlagbar ist. Die Elektroden 12, 13 stehen über entsprechende Durchkontaktierungen mit Anschlüssen 10, 11 entsprechender Polarität an der Innenseite E des Deckels 2b in elektrisch leitender Verbindung. Die Anschlüsse 10, 11 an der Innenseite E des Deckels 2b stellen bei geschlossenem Deckel 2b einen elektrischen Kontakt zu den Randabschnitten 8a und 9a des Kontaktelements 2c her und stehen mit den Kontaktabschnitten 8, 9 entsprechender Polarität in elektrisch leitender Verbindung.

Um die Piezokeramik 3 zur Schwingung anzuregen, muss ein elektrisches Wechselfeld in der Piezokeramik 3 erzeugt werden. Dies geschieht durch Anlegen einer Wechselspannung an die flächig aufgebrachten Elektroden 4, 5 der Piezokeramik 3.

Durch den Umkontakt 5a, der über die Mantelfläche C der Piezokeramik 3 verläuft, können die Kontaktflächen 6, 7 beider Elektroden 4, 5 der Piezokeramik 3, d.h. die Kontaktierungspunkte für Plus- und Minuspol, auf einer Seite der Piezokeramik 3 untergebracht werden.

Die Piezokeramik 3 hat ein symmetrisches Design zur Ausbildung einer optimalen Schallkeule, wobei die mittig angeordnete erste Elektrode 4 einen aktiven Bereich für die Schallerzeugung bildet und zusätzlich ein passiver Bereich mit vier Umkontakten 5a und Kontaktflächen 7 vorhanden ist.

Das als Kontaktelement 2c ausgebildete Substrat ist beispielsweise mittels eines Sputter-Prozesses (Physikalische Gasphasenabscheidung bzw. PVD) kostengünstig realisierbar.

Die akustische Kopplung der Piezokeramik 3 mit dem Kontaktelement 2c erfolgt durch vollflächige Verklebung. Über die Verklebung erfolgt gleichzeitig die elektrische Kontaktierung der Piezokeramik 3 mit dem Kontaktelement 2c, so dass keine zusätzliche Kontaktierung z.B. durch Löten oder Federkontakte notwendig ist. Der galvanische Kontakt zwischen der Piezokeramik 3 und dem Kontaktelement 2c wird über die Oberflächenrauheit der Fügepartner realisiert. Ein leitfähiger Klebstoff ist daher nicht zwingend erforderlich. Die Kontaktierung der Center-Elektrode (Pluspol) 4 und der Kontaktflächen 7 des Minuspols 5 der Piezokeramik 3 auf dem Kontaktelement 2c wird durch die spezielle Elektrodenstruktur in Gestalt der Kontaktabschnitte 8, 9 und der speziellen Positionierung der Piezokeramik 3 ermöglicht.

Die Kontaktierung der beiden Elektroden 4, 5 der Piezokeramik 3 mit dem Kontaktelement 2c gestaltet sich daher als besonders einfach. Eine funktionsbestimmende Klebung (akustische Kopplung) und elektrische Kontaktierung sind in einem Montageschritt möglich.

Die oben beschriebene Anordnung kann in ein Gehäuse 2 mit entsprechenden elektrischen Kontaktabschnitten 8, 9 montiert werden. Eine andere Möglichkeit besteht in der Implementierung des obigen Designs in ein topfförmiges Gehäuse 2a.

Eine Implementierung bzw. Integration des Kontaktelements 2c in das Gehäuse 2 ist möglich, wobei das Gehäuse 2 aus Konstruktionskeramik oder Kunststoff hergestellt sein kann. Die Fortführung der Elektrodenbahnen der Kontaktabschnitte 8, 9 erfolgt beispielsweise über die Metallisierung (z.B. mittels PVD) der Innenwandung des Kontaktelements 2c und/oder des Gehäuses 2 auf Kontaktierungsflächen in einem einfach zugänglichen Absatz im Gehäuse 2. Die Innenmetallisierung des Gehäuses 2 bietet zusätzliche Schirmung.

Der Verschluss des Gehäuses 2 erfolgt mit einem Deckel 2b in Gestalt der Leiterplatte 2d (FR4), wobei das Design der Leiterplatte 2d auch in Hybrid-Technik (gedruckte Schaltung auf Aluminiumoxidkeramik) erfolgen kann.

Die Verklebung der Leiterplatte 2d mit dem restlichen Gehäuse 2 kann durch einen nichtleitenden Klebstoff erfolgen, wobei der galvanische Kontakt zwischen den Kontaktflächen des Gehäuses 2 und den PCB-Elektrodenflächen über die Oberflächenrauheit erfolgt.

Der erfindungsgemäße Ultraschallwandler 1 besteht demnach nur aus drei Teilen mit integrierter Kontaktierung der Piezoscheibe 3. Dadurch ergibt sich eine definierte Schnittstelle zur Zähler-Elektronik (Lötkontakt oder Steckverbinder) sowie eine einfache automatisierbare Aufbau- und Verbindungstechnik, wobei die Montage von einer Seite erfolgen kann.

### Bezugszeichenliste

- 1: Ultraschallwandler
- 2: Gehäuse
- 2a: Topf
- 2b: Deckel
- 2c: Kontaktelement
- 2d: Leiterplatte
- 3: Piezokeramik
- 4: Elektrode (Plus) (Piezokeramik)
- 5: Elektrode (Minus) (Piezokeramik)
- 5a: Umkontakt Elektrode (Minus)
- 6: Kontaktfläche der Elektrode (Plus)
- 7: Kontaktfläche der Elektrode (Minus)
- 8: Kontaktabschnitt für Elektrode (Plus)
- 8a: Rand des Kontaktelements zur Kontaktierung des Kontaktabschnitts (Plus)
- 9: Kontaktabschnitt für Elektrode (Minus)
- 9a: Rand des Kontaktelements zur Kontaktierung des Kontaktabschnitts (Minus)
- 10: Anschluss (Plus) (Deckelinnenseite)
- 11: Anschluss (Minus) (Deckelinnenseite)
- 12: Elektrode (Plus) (Deckel)
- 13: Elektrode (Minus) (Deckel)
- A: Erste Seite (Unterseite) der Piezokeramik
- B: Zweite Seite (Oberseite) der Piezokeramik
- C: Dritte Seite (Mantelfläche) der Piezokeramik
- D: Außenseite des Deckels
- E: Innenseite des Deckels

## Patentansprüche

1. Ultraschallwandler (1), insbesondere zur Fluidmengenmessung, umfassend: ein Gehäuse (2), in welchem ein Kontaktelement (2c) und eine Piezokeramik (3) angeordnet sind, wobei die Piezokeramik (3) zwei Elektroden (4, 5) unterschiedlicher Polarität umfasst, die auf verschiedene Seiten (A, B) der Piezokeramik (3) aufgebracht sind, wobei Kontaktflächen (6, 7) zur elektrischen Kontaktierung beider Elektroden (4, 5) auf derselben Seite (A) der Piezokeramik (3) angeordnet sind, und das Kontaktelement (2c) wenigstens zwei Kontaktabschnitte (8, 9) unterschiedlicher Polarität aufweist, die mit den Kontaktflächen (6, 7) beider Elektroden (4, 5) entsprechender Polarität in elektrisch leitendem Kontakt stehen, **dadurch gekennzeichnet, dass** das Kontaktelement (2c) topfförmig ausgebildet ist, wobei die Kontaktabschnitte (8, 9) am Boden des Kontaktelements (2c) angeordnet sind und über vom Boden vorstehende Randabschnitte (8a, 9a) des Kontaktelements (2c) elektrisch kontaktierbar sind.

2. Ultraschallwandler (1) nach Anspruch 1, **dadurch gekennzeichnet, dass** die jeweiligen Kontaktabschnitte (8, 9) des Kontaktelements (2c) in flächigem Kontakt mit den entsprechenden Kontaktflächen (6, 7) der Elektroden (4, 5) stehen.

3. Ultraschallwandler (1) nach Anspruch 1 oder 2, **dadurch gekennzeichnet, dass** eine von der Piezokeramik (3) abweisende Seite der ersten Elektrode (4) die Kontaktfläche (6) der ersten Elektrode (4) bildet.

4. Ultraschallwandler (1) nach einem der vorangehenden Ansprüche, **dadurch gekennzeichnet, dass** die erste Elektrode (4) eine erste Seite (A) der Piezokeramik (3) teilweise bedeckt und/oder kontaktiert, wobei die erste Elektrode (4) vorzugsweise mittig auf der ersten Seite (A) der Piezokeramik (3) angeordnet ist, bevorzugt derart, dass auf der ersten Seite (A) der Piezokeramik (3) eine ringförmige Fläche verbleibt, die nicht von der ersten Elektrode (4) bedeckt ist.

5. Ultraschallwandler (1) nach einem der vorangehenden Ansprüche, **dadurch gekennzeichnet, dass** die zweite Elektrode (5) eine zweite Seite (B) der Piezokeramik (3) vorzugsweise vollflächig bedeckt und/oder kontaktiert, wobei bevorzugt wenigstens eine Kontaktfläche (7) der zweiten Elektrode (5) auf der ersten Seite (A) der Piezokeramik (3) angeordnet ist und durch einen Umkontakt (5a) mit der zweiten Elektrode (5) elektrisch leitend verbunden ist, wobei der Umkontakt (5a) vorzugsweise über eine dritte Seite (C) der Piezokeramik (3) verläuft.

6. Ultraschallwandler (1) nach einem der vorangehenden Ansprüche, **dadurch gekennzeichnet, dass** die zweite Elektrode (5) zwei, drei, vier oder mehr Kontaktflächen (7) aufweist, die vorzugsweise identisch ausgebildet und/oder symmetrisch und/oder äquidistant um die erste Elektrode (4) angeordnet sind, bevorzugt randseitig auf der ersten Seite (A) der Piezokeramik (3).

7. Ultraschallwandler (1) nach einem der vorangehenden Ansprüche, **dadurch gekennzeichnet, dass** die Piezokeramik (3) als Piezokeramikscheibe oder-platte (3) ausgebildet ist und/oder sich in einer Ebene erstreckt.

8. Ultraschallwandler (1) nach einem der vorangehenden Ansprüche, **dadurch gekennzeichnet, dass** das Gehäuse (2) aus Keramik wie beispielsweise Aluminiumoxid oder aus Kunststoff wie beispielsweise PPS hergestellt ist, vorzugsweise im Gieß- oder Spritzgussverfahren.

9. Ultraschallwandler (1) nach einem der vorangehenden Ansprüche, **dadurch gekennzeichnet, dass** sich die Kontaktabschnitte (8, 9) auf derselben Oberfläche des Kontaktelements (2c) und/oder in derselben Ebene befinden.

10. Ultraschallwandler (1) nach einem der vorangehenden Ansprüche, **dadurch gekennzeichnet, dass** das Kontaktelement (2c) als Membran ausgebildet ist, über welche die akustische Kopplung der Piezokeramik (3) erfolgt, wobei die Piezokeramik (3) vorzugsweise vollflächig mit dem Kontaktelement (2c) verklebt ist.

11. Ultraschallwandler (1) nach einem der vorangehenden Ansprüche, **dadurch gekennzeichnet, dass** die Kontaktabschnitte (8, 9) als Beschichtung oder Metallisierung auf das Kontaktelement (2c) aufgebracht sind oder durch Einbettung elektrisch leitfähiger Materialien, bevorzugt in Partikelform, in das Kontaktelement (2c) eingearbeitet sind.

12. Ultraschallwandler (1) nach einem der vorangehenden Ansprüche, **dadurch gekennzeichnet, dass** das Gehäuse (2) einen Deckel (2b) mit Elektroden (12, 13) unterschiedlicher Polarität aufweist, wobei die Elektroden (12, 13) bei geschlossenem Deckel (2b) in elektrisch leitender Verbindung mit den Kontaktabschnitten (8, 9) entsprechender Polarität stehen, sodass die Piezokeramik (3) über die Elektroden des Deckels (2b) mit einer Wechselspannung beaufschlagbar ist.

13. Ultraschallwandler (1) nach Anspruch 12, **dadurch gekennzeichnet, dass** die Elektroden (12, 13) bei geschlossenem Deckel (2b) an der Außenseite des Deckels (2b) angeordnet sind und vorzugsweise über Durchkontaktierung mit Anschlüssen (10, 11) entsprechender Polarität an der Innenseite (E) des Deckels (2b) in elektrisch leitender Verbindung stehen, wobei die Anschlüsse (10, 11) an der Innenseite (E) des Deckels (2b) bei geschlossenem Deckel (2b) mit den Kontaktabschnitten (8, 9) entsprechender Polarität in elektrisch leitender Verbindung und/oder in Kontakt stehen.

14. Verfahren zur Herstellung eines Ultraschallwandlers (1) nach Anspruch 12, umfassend die Schritte:
a. Anordnen der Piezokeramik (3) in dem Gehäuse (2), sodass die Kontaktflächen (6, 7) der Piezokeramik (3) mit den Kontaktabschnitten (8, 9) entsprechender Polarität des Kontaktelements (2) in elektrisch leitendem Kontakt stehen;
b. Verschließen des Gehäuses (2) mit dem Deckel (2b).

## Claims

1. Ultrasonic transducer (1), in particular for the measurement of fluid volumes, comprising: a housing (2) in which a contact element (2c) and a piezoceramic (3) are arranged, where said piezoceramic (3) comprises two electrodes (4, 5) of different polarity which are applied onto different sides (A, B) of said piezoceramic (3), where contact surfaces (6, 7) for the electrical contact of said two electrodes (4, 5) are arranged on the same side (A) of said piezoceramic (3), and said contact element (2c) comprises at least two contact sections (8, 9) of different polarity which are in electrically conductive contact with said contact surfaces (6, 7) of said two electrodes (4, 5) of corresponding polarity, **characterized in that** said contact element (2c) is formed to be pot-shaped, where said contact sections (8, 9) are arranged at the base of said contact element (2c) and are electrically contactable by way of edge sections (8a, 9a) of said contact element (2c) protruding from said base.

2. Ultrasonic transducer (1) according to claim 1, **characterized in that** said respective contact sections (8, 9) of said contact element (2c) are in planar contact with said corresponding contact surfaces (6, 7) of said electrodes (4, 5).

3. Ultrasonic transducer (1) according to claim 1 or 2, **characterized in that** a side of said first electrode (4) facing away from said piezoceramic (3) forms said contact surface (6) of said first electrode (4).

4. Ultrasonic transducer (1) according to one of the preceding claims, **characterized in that** said first electrode (4) in part covers and/or contacts a first side (A) of said piezoceramic (3), where said first electrode (4) is preferably arranged centrally on said first side (A) of said piezoceramic (3), preferably such that a ring-shaped surface remains on said first side (A) of said piezoceramic (3) and is not covered by said first electrode (4).

5. Ultrasonic transducer (1) according to one of the preceding claims, **characterized in that** said second electrode (5) covers and/or contacts a second side (B) of said piezoceramic (3) preferably over the entire surface, where preferably at least one contact surface (7) of said second electrode (5) is arranged on said first side (A) of said piezoceramic (3) and is connected by a deflected contact (5a) to said second electrode (5) in an electrically conductive manner, where said deflected contact (5a) runs preferably over a third side (C) of said piezoceramic (3).

6. Ultrasonic transducer (1) according to one of the preceding claims, **characterized in that** said second electrode (5) comprises two, three, four or more contact surfaces (7) which are preferably formed identically and/or arranged symmetrically and/or equidistantly around said first electrode (4), preferably at the edge side on said first side (A) of said piezoceramic (3).

7. Ultrasonic transducer (1) according to one of the preceding claims, **characterized in that** said piezoceramic (3) is formed as a piezoceramic disk or plate (3) and/or extends in a plane.

8. Ultrasonic transducer (1) according to one of the preceding claims, **characterized in that** said housing (2) is produced from ceramic material such as aluminum oxide or from plastic material such as PPS, preferably in a casting or injection molding process.

9. Ultrasonic transducer (1) according to one of the preceding claims, **characterized in that** said contact sections (8, 9) are located on the same surface of said contact element (2c) and/or in the same plane.

10. Ultrasonic transducer (1) according to one of the preceding claims, **characterized in that** said contact element (2c) is formed as a membrane, via which the acoustic coupling of said piezoceramic (3) is effected, where said piezoceramic (3) is preferably adhesively bonded over the entire surface to said contact element (2c).

11. Ultrasonic transducer (1) according to one of the preceding claims, **characterized in that** said contact sections (8, 9) are applied as a coating or metallization onto said contact element (2c) or are incorporated into said contact element (2c) by embedding electrically conductive materials, preferably in particle form.

12. Ultrasonic transducer (1) according to one of the preceding claims, **characterized in that** said housing (2) comprises a lid (2b) with electrodes (12, 13) of different polarity, where said electrodes (12, 13) are in electrically conductive connection to said contact sections (8, 9) of corresponding polarity when said lid (2b) is closed, so that said piezoceramic (3) can be acted upon with an alternating voltage through said electrodes of said lid (2b).

13. Ultrasonic transducers (1) according to claim 12, **characterized in that** said electrodes (12, 13) are arranged on the outer side of said lid (2b) when said lid is closed (2b) and are in electrically conductive connection preferably by way of vias to terminals (10, 11) of corresponding polarity on the inner side (E) of said lid (2b), where said terminals (10, 11) on said inner side (E) of said lid are in electrically conductive connection to and/or in contact with said contact sections (8, 9) of corresponding polarity when said lid (2b) is closed.

14. Method for producing an ultrasonic transducer (1) according to claim 12, comprising the steps of:
a. arranging said piezoceramic (3) in said housing (2) so that said contact surfaces (6, 7) of said piezoceramic (3) are in electrically conductive contact with said contact sections (8, 9) of corresponding polarity of said contact element (2);
b. closing said housing (2) with said lid (2b).

## Revendications

1. Transducteur à ultrasons (1), en particulier destiné à mesurer des quantités de fluide, comprenant : un boîtier (2) au sein duquel sont agencés un élément de contact (2c) et une piézocéramique (3), dans lequel la piézocéramique (3) comprend deux électrodes (4, 5) de polarité différente qui sont appliquées sur différents côtés (A, B) de la piézocéramique (3), dans lequel des surfaces de contact (6, 7) destinées à créer un contact électrique entre les deux électrodes (4, 5) sont agencées sur le même côté (A) de la piézocéramique (3), et dans lequel l'élément de contact (2c) présente au moins deux parties de contact (8, 9) de polarité différente qui sont en contact électriquement conducteur avec les surfaces de contact (6, 7) des deux électrodes (4, 5) de polarité correspondante, **caractérisé en ce que** l'élément de contact (2c) est réalisé en forme de pot, dans lequel les parties de contact (8, 9) sont agencées sur le fond de l'élément de contact (2c) et peuvent être mises en contact électrique par l'intermédiaire de parties de bord (8a, 9a) faisant saillie depuis le fond de l'élément de contact (2c).

2. Transducteur à ultrasons (1) selon la revendication 1, **caractérisé en ce que** les parties de contact (8, 9) respectives de l'élément de contact (2c) sont en contact à plat avec les surfaces de contact (6, 7) correspondantes des électrodes (4, 5).

3. Transducteur à ultrasons (1) selon la revendication 1 ou 2, **caractérisé en ce qu'**un côté de la première électrode (4) qui se détourne de la piézocéramique (3) forme la surface de contact (6) de la première électrode (4).

4. Transducteur à ultrasons (1) selon l'une quelconque des revendications précédentes, **caractérisé en ce que** la première électrode (4) recouvre partiellement, et/ou est partiellement en contact avec, un premier côté (A) de la piézocéramique (3), dans lequel la première électrode (4) est de manière préférée agencée au centre du premier côté (A) de la piézocéramique (3), de manière préférée de telle manière qu'il reste, sur le premier côté (A) de la piézocéramique (3), une surface annulaire qui n'est pas recouverte par la première électrode (4).

5. Transducteur à ultrasons (1) selon l'une quelconque des revendications précédentes, **caractérisé en ce que** la seconde électrode (5) recouvre de manière préférée intégralement, et/ou est de manière préférée intégralement en contact avec, un deuxième côté (B) de la piézocéramique (3), dans lequel de manière préférée au moins une surface de contact (7) de la seconde électrode (5) est agencée sur le premier côté (A) de la piézocéramique (3) et est reliée de manière électriquement conductrice à la seconde électrode (5) grâce à un contact périphérique (5a), dans lequel le contact périphérique (5a) s'étend de manière préférée sur un troisième côté (C) de la piézocéramique (3).

6. Transducteur à ultrasons (1) selon l'une quelconque des revendications précédentes, **caractérisé en ce que** la seconde électrode (5) présente deux, trois, quatre ou plus de quatre surfaces de contact (7) qui sont de manière préférée identiques et/ou sont agencées de manière symétrique et/ou équidistante autour de la première électrode (4), de manière préférée côté bord sur le premier côté (A) de la piézocéramique (3).

7. Transducteur à ultrasons (1) selon l'une quelconque des revendications précédentes, **caractérisé en ce que** la piézocéramique (3) est conçue comme un disque en piézocéramique ou une plaque en piézocéramique (3) et/ou s'étend dans un plan.

8. Transducteur à ultrasons (1) selon l'une quelconque des revendications précédentes, **caractérisé en ce que** le boîtier (2) est fabriqué en céramique telle que l'oxyde d'aluminium ou en plastique tel que le PPS, de manière préférée selon un procédé de moulage ou d'injection.

9. Transducteur à ultrasons (1) selon l'une quelconque des revendications précédentes, **caractérisé en ce que** les parties de contact (8, 9) sont situées sur la même surface de l'élément de contact (2c) et/ou dans le même plan.

10. Transducteur à ultrasons (1) selon l'une quelconque des revendications précédentes, **caractérisé en ce que** l'élément de contact (2c) est conçu comme une membrane, par l'intermédiaire de laquelle se produit le couplage acoustique de la piézocéramique (3), dans lequel la piézocéramique (3) est de manière préférée collée sur toute sa surface à l'élément de contact (2c).

11. Transducteur à ultrasons (1) selon l'une quelconque des revendications précédentes, **caractérisé en ce que** les parties de contact (8, 9) sont appliquées sous forme de revêtement ou de métallisation sur l'élément de contact (2c) ou sont incluses dans l'élément de contact (2c) par incorporation de matériaux électriquement conducteurs, de manière préférée sous forme de particules.

12. Transducteur à ultrasons (1) selon l'une quelconque des revendications précédentes, **caractérisé en ce que** le boîtier (2) présente un couvercle (2b) muni d'électrodes (12, 13) de polarité différente, dans lequel les électrodes (12, 13) sont en liaison électriquement conductrice avec les parties de contact (8, 9) de polarité correspondante lorsque le couvercle (2b) est fermé, de sorte que la piézocéramique (3) peut être soumise à une tension alternative par l'intermédiaire des électrodes du couvercle (2b).

13. Transducteur à ultrasons (1) selon la revendication 12, **caractérisé en ce que** les électrodes (12, 13) sont agencées sur le côté extérieur du couvercle (2b) lorsque le couvercle (2b) est fermé et sont de manière préférée en liaison électriquement conductrice avec des bornes (10, 11) de polarité correspondante sur le côté intérieur (E) du couvercle (2b), dans lequel les bornes (10, 11) sont en liaison électriquement conductrice et/ou en contact avec les parties de contact (8, 9) de polarité correspondante sur le côté intérieur (E) du couvercle (2b) lorsque le couvercle (2b) est fermé.

14. Procédé de fabrication d'un transducteur à ultrasons (1) selon la revendication 12, comprenant les étapes consistant à :
a. agencer la piézocéramique (3) dans le boîtier (2) de sorte que les surfaces de contact (6, 7) de la piézocéramique (3) sont en contact électriquement conducteur avec les parties de contact (8, 9) de polarité correspondante de l'élément de contact (2) ;
b. fermer le boîtier (2) avec le couvercle (2b).
